# EUROPEAN PATENT APPLICATION

(11) **EP 0 522 252 A1**
(43) Date of publication of application: **13.01.1993**
(21) Application number: 92107268.2
(22) Date of filing: 29.04.1992
(51) Int. Cl.: H05K 7/18, H02B 1/30

(54) **Sectional electric panelboard**

(30) Priority: 09.07.1991 IT MI911901
(71) Applicant: SCHIAVI S.R.L., I-20075 Lodi (Milano) (IT)
(72) Inventor: Negri, Virginio, I-20075 Lodi (Milano) (IT); Marchesi, Massimo, I-20070 Massalengo (Milano) (IT)
(74) Representative: Dr. Ing. A. Racheli & C. S.r.l.

(57) **Abstract**

A sectional electric panelboard, whose supporting structure (1) consists of two rectangular frames (2, 3), which are equal to one another and connected at the corners by four equal braces (5), with a square coupling and fastened by means of screws (20), the supporting structure (1) having fastened to it panels (8; 9, 10) and a hinged door (7), which carry inside a perimetral strip (13), suitable for abutting against beadings (14, 15) which run inside the perimeter of each face of the supporting structure.

## Description

The present invention refers to a sectional electric panelboard, consisting of elements which can be assembled easily and quickly on the spot.

Vertical electric panelboards generally have one single supporting structure, that is a parallelepiped-shaped framework made from metallic sections welded together. Then a door, opening with a hinge, a rear panel, side panels, top and bottom panels are applied to such framework, the whole with sealing strips which guarantee an efficient tight seal.

The drawback with such panelboards is that they take up a large amount of space while they are being stored in the warehouse and during transport, resulting in an increase in the cost of the end products, as well as practical problems in handling them.

Other panelboards of the sectional type have been proposed, and these are generally made up of metal sections with their ends cut at 45°, which are capable of being assembled together to form rectangular frames by means of the interposition of angle squares and fastening with screws. Suitable connection fittings are then foreseen at the joining points of the three sections.

Such already known sectional panelboards require long and laborious assembly operations, and afford many points for possible infiltration of water, which have to be appropriately sealed in order to guarantee a good watertight condition.

The aim of the present invention is to provide a sectional electric panelboard, which can be assembled in a quick and easy manner, without the use of special fittings, and which offers good watertight qualities.

This aim has been achieved with the panelboard according to the invention, whose supporting structure substantially consists of two rectangular frames, one at the front and one at the back, which are perfectly equal to one another and connected at the four corners by braces which are also equal to one another and couple perfectly with the corners of the frames, fastening being effected by means of screws.

A door opening with a hinge is mounted onto one of the said rectangular frames, while the closing back panel is applied to the other frame, or alternatively a further door opening with a hinge is mounted.

In the same way, once the supporting structure has been formed, the side panels and the top and bottom panels are applied, having closed molding sealing strips, which abut against the framework in order to guarantee good watertight properties.

At the ends of the braces, which are L-shaped, in order to be able to couple with the apexes of the rectangular frames, respective jointings are provided, preferably consisting of silicone rubber in paste form, which is spread over them to determine a good coupling seal between such elements.

Further characteristics of the invention will be made clearer by the description given below, which refers to one of its purely exemplary embodiments, and therefore is not restrictive, and which is illustrated in the appended drawings, in which:
- Figure 1: is a diagrammatic, axonometric view illustrating, in exploded form, the essential elements which go to form the electric panelboard according to the invention;
- Figure 2: is an enlarged view with respect to the one in figure 1, showing the end of a brace and the corner of a rectangular frame forming the structure of the panelboard before coupling;
- Figure 3: is a view like the one in figure 2, in which such elements are coupled with each other;
- Figure 4: is a view from the back of figure 2.

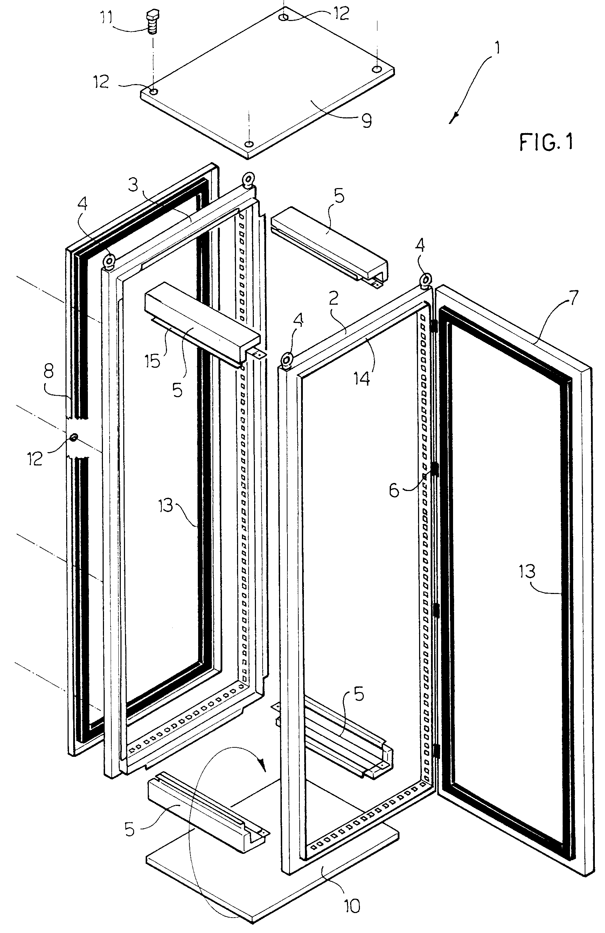

With reference to such figures, and at this moment to figure 1 in particular, it can be seen that the sectional electric panelboard according to the present invention has a supporting structure or framework 1 consisting substantially of two rectangular frames, or carlines 2, 3, equal to one another and having at the top lifting eyebolts 4.

The two frames 2 and 3 are connected together at their apexes by means of four braces 5, which are equal to one another, in the manner which will be described below.

A door 7 is applied to the frame 2, by means of hinges 6, while the back panel 8 of the panelboard is applied to the frame 3.

Once the supporting structure 1 has been realized, in the manner which will be described below, side panels (not illustrated), a top panel 9 and bottom panel or base 10, which are illustrated in diagrammatic form only in figure 1, are applied to it.

The fastening of the various panels is effected by means of screws 11 passing into holes 12 foreseen on the perimeters of the former, only some of the holes being illustrated in figure 1, and possibly by the application of spacers onto the outside of the structure 1.

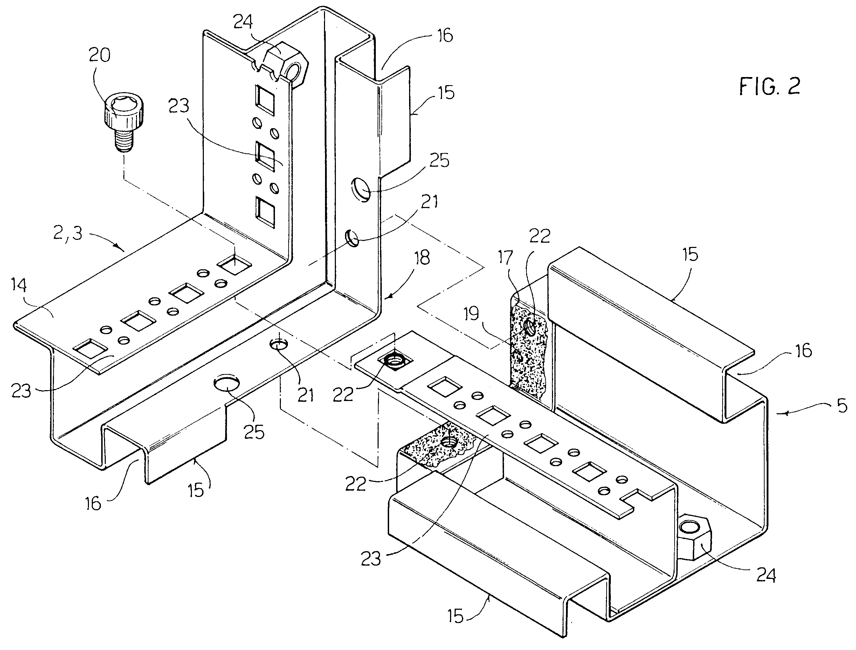

The watertight and dust-proof properties are ensured by closed molding sealing strips 13, foreseen on the panels, further inside than the said holes 12. The strips 13 abut against a rectangular beading 14, which projects externally at right angles to the plane of the frames 2 and 3, or against the beadings 15 (see figures 2, 3 and 4 also), which, after the formation of the structure 1, determine rectangular moldings which project perpendicularly to the sides of the structure itself.

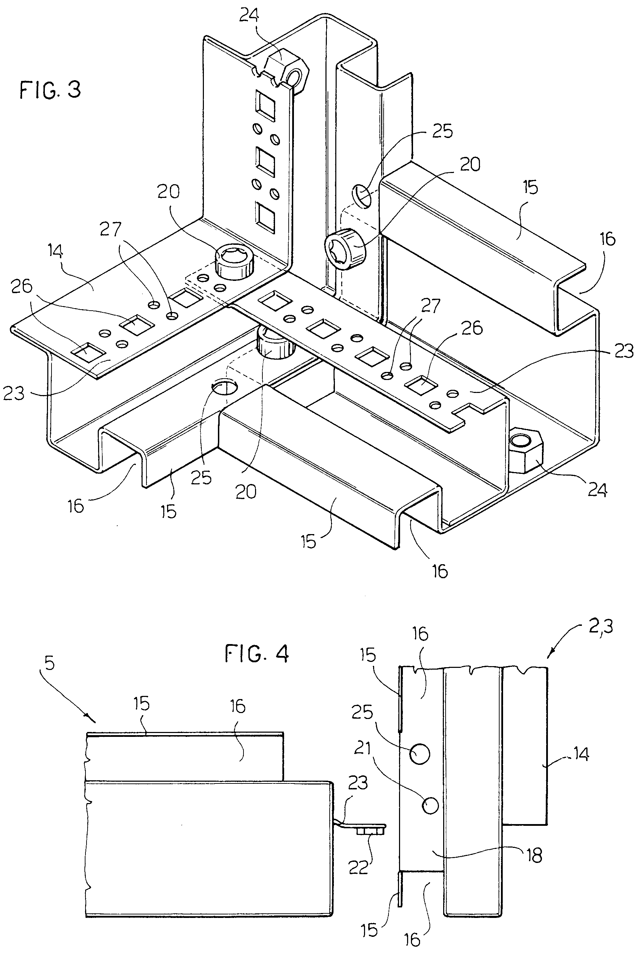

With reference to the figures from 2 to 4, a more detailed description is now given of the coupling of a brace 5 with a rectangular frame 2 or 3, whose outlines can be clearly seen particularly in figures 2 and 3. The braces 5 are substantially L-shaped, with their longitudinal edges bent back to form respective channels 16, limited by the said end edges 15, which are perpendicular to the plane of the respective flange of the L. The channels 16 are interrupted in correspondence with the ends 17 of the braces, which are bend inwards, in such a way as to define a square which is a raised L with respect to the outline of the brace. Such end 17, onto which silicone rubber 19 is suitably spread, matches perfectly with the corner 18 of the rectangular frame 2, 3, in correspondence with which the said edges 15 of the frames, which also delimit an inner channel 16, are interrupted in such a way that after coupling there is continuity both of the edges 15 and of the channels 16 of the braces 5 and of the frames 2 and 3 (see figure 3). The silicone jointing 19 guarantees the coupling seal, and is fastened by means of screws 20 passing through holes 21 foreseen in the corner 18 of the frame 2, 3 and being screwed into threaded holes or nuts 22 foreseen in correspondence with the ends 17 of the braces 15. An additional fastening point is foreseen at the end of a drilled strip 23, rigidly connected to a flange of the L-shaped brace 5 and parallel to it. Such end 17 is located inside a corresponding drilled strip 23 foreseen on the frame 2, 3, and makes up an extension towards the inside of the said projection 14. In this case also, there is a kind of continuity between the drilled strip 23 of the braces 5 and of the frames 2, 3, in such a way as to obtain rectangular drilled moldings, substantially known per se in electric panelboards, and which serve to fasten, for example, support plates for the equipment in different positions.

According to the invention, the drilling foreseen on the strips 23 is to the best advantage made up of a succession of square holes 26 and pairs of circular holes 27, which are repeated at intervals of 25 mm. The side of the holes 26 is 9 mm, while the diameter of the holes 27 is 4.5 mm and their centre distance is 12.5 mm.

In the figures 2 and 3 earthing blocks 24 can be seen, which are arranged on the braces 5 and on the frames 2 and 3 in order to guarantee the electrical continuity between such elements, by means of earth cables which are not illustrated.

In the figures from 2 to 4, two auxiliary holes 25 are also illustrated near the corner 18 of the frame 2, 3, serving to fasten a possible square provided with a jointing and suitable for sealing on the joining lines between the cut edges 15 of the braces 5 and of the frames 2, 3. Such square is not illustrated or described in detail since it constitutes the object of a separate patent application which is being filed on the same date as the present application.

In the previous description, for practical reasons, the equivalent parts of the braces 5 and of the frames 2, 3 have been indicated with the same reference numbers (for examples 15, 16, 23).

From what has been described above, the advantages of the solution proposed by the present invention are obvious in that it allows the electric panelboard to be assembled quickly, simply by screwing three screws 20 for each corner.

The space taken up by the dismantled panelboard substantially corresponds to that taken up by a rectangular frame 2, 3, with a thickness that is about twice as much as that of such frame, and therefore it can be warehoused and/or transported with ease.

## Claims

1. A sectional electric panelboard comprising a metallic supporting structure (1), consisting of a parallelepiped framework, covered with panels (8, 9, 10) and with one or two access doors (7), characterized in that said supporting structure (1) consists of two rectangular frames (2, 3), equal and opposed, and joined to each other at the corners by four braces (5) all of which are equal to one another.

2. A sectional electric panelboard according to claim 1, characterized in that said braces (5) have a substantially L-shaped outline, with ends (17) which are square coupled perfectly at the corners (18) of said frames (2, 3), their fastening being effected by means of screws (20).

3. A sectional electric panelboard according to claim 1 or 2, characterized in that a jointing (19) is positioned in correspondence with the said ends (17) of the braces.

4. A sectional electric panelboard according to any one of the previous claims, characterized in that the braces (5) and the frames (2, 3) have channels (16) delimited by beadings (15) which after the coupling of such elements, determine rectangular moldings, against which sealing strips abut, which are carried by said covering panels.

5. A sectional electric panelboard according to any one of the previous claims, characterized in that said rectangular frames (2, 3) have on their outer face a perimetral beading (14), against which a corresponding sealing strip (13) abuts which is carried inside the access door (7) applied to the frame (2), or respectively by the back panel (8) applied to the frame (3).

6. A sectional panelboard according to claim 5, characterized in that the said edges (14) extend inside the frames (2, 3) to form drilled strips (23), running along the sides of the frames (2, 3), and suitable for coupling with corresponding drilled strips (23) which are carried by the braces (5).

7. A sectional electric panelboard according to claim 6, characterized in that said drilled strips (23) comprise a succession of square holes (26) and pairs of circular holes (27) which are repeated at a regular interval.

8. A sectional electric panelboard according to any one of the previous claims, characterized in that inside the braces (5) and the frames (2, 3) earthing blocks (24) are provided, suitable for guaranteeing the electrical continuity between the elements.

9. A sectional electric panelboard according to any one of the previous claims, characterized in that nuts for lifting eyebolts (4) are welded at the upper ends of the said rectangular frames (2, 3).
